## Europäisches Patentamt
## European Patent Office
## Office européen des brevets

(19)

(11) Numéro de publication: **0 194 936**
**B1**

(12) **FASCICULE DE BREVET EUROPEEN**

(45) Date de publication du fascicule du brevet:
**06.09.89**

(51) Int. Cl.⁴: **H01L 29/74, H01L 29/10**

(21) Numéro de dépôt: **86400490.8**

(22) Date de dépôt: **07.03.86**

(54) Thyristor de protection sans gachette.

(30) Priorité: **12.03.85 FR 8503626**

(43) Date de publication de la demande:
**17.09.86 Bulletin 86/38**

(45) Mention de la délivrance du brevet:
**06.09.89 Bulletin 89/36**

(84) Etats contractants désignés:
**CH DE FR GB IT LI**

(56) Documents cités:
**DE-A- 2 231 777**
**US-A- 4 325 074**

(73) Titulaire: **THOMSON-CSF, 51, Esplanade du Général de Gaulle, F-92800 Puteaux(FR)**

(72) Inventeur: **Noguier, Jean-Pierre, THOMSON-CSF SCPI 19, avenue de Messine, F-75008 Paris(FR)**
Inventeur: **Montaut, Jean-Paul, THOMSON-CSF SCPI 19, avenue de Messine, F-75008 Paris(FR)**

(74) Mandataire: **Rinuy, Santarelli, 14, avenue de la Grande Armée, F-75017 Paris(FR)**

ACTORUM AG

## Description

L'invention concerne les composants semiconducteurs et plus particulièrement les éléments de protection contre les surtensions.

On a déjà proposé d'utiliser un thyristor sans électrode de gâchette, pour protéger des circuits contre des surtensions apparaissant entre deux bornes du circuit ; le thyristor est placé entre ces deux bornes ; il est normalement bloqué mais devient passant si la tension à ses bornes dépasse un seuil déterminé ; il dérive alors un courant important et empêche la destruction du circuit à protéger. Si le circuit doit être protégé contre des surtensions positives et négatives, un triac de protection, sans électrode de gâchette sera utilisé.

La Demanderesse s'est aperçue que les thyristors ou triacs sans gâchette que l'on peut utiliser comme éléments de protection contre les surtensions doivent avoir des caractéristiques électriques différentes de celles que l'on exige de thyristors ou triacs utilisés dans d'autres applications et notamment dans la commutation commandée de courants.

En particulier, les triacs de protection doivent être capables de supporter le passage de courants extrêmement élevés pendant des temps brefs (temps nécessaire à la disparition des surtensions) ; au contraire un triac en commutation commandée doit d'abord être capable de supporter la dissipation d'une puissance _moyenne_ élevée avant d'être capable de dériver une puissance _transitoire_ élevée. D'autre part, un triac de protection doit de préférence avoir un courant de maintien assez important ; le courant de maintien est la valeur du courant qui passe dans le triac et au-dessous de laquelle le triac ne peut plus rester conducteur et se rebloque ; au contraire, un triac utilisé en commutation commandée doit le plus souvent avoir un courant de maintien aussi faible que possible ; en effet, le triac en commutation commandée est beaucoup mieux contrôlé s'il se bloque à un instant aussi proche que possible du passage à zéro du courant. Au contraire le triac de protection doit se bloquer rapidement après disparition de la surtension et surtout, si son courant de maintien était trop faible, il risquerait de rester conducteur même après un retour à une valeur normale de la tension entre les bornes du circuit à protéger (notamment lorsque ces bornes sont les bornes d'alimentation du circuit).

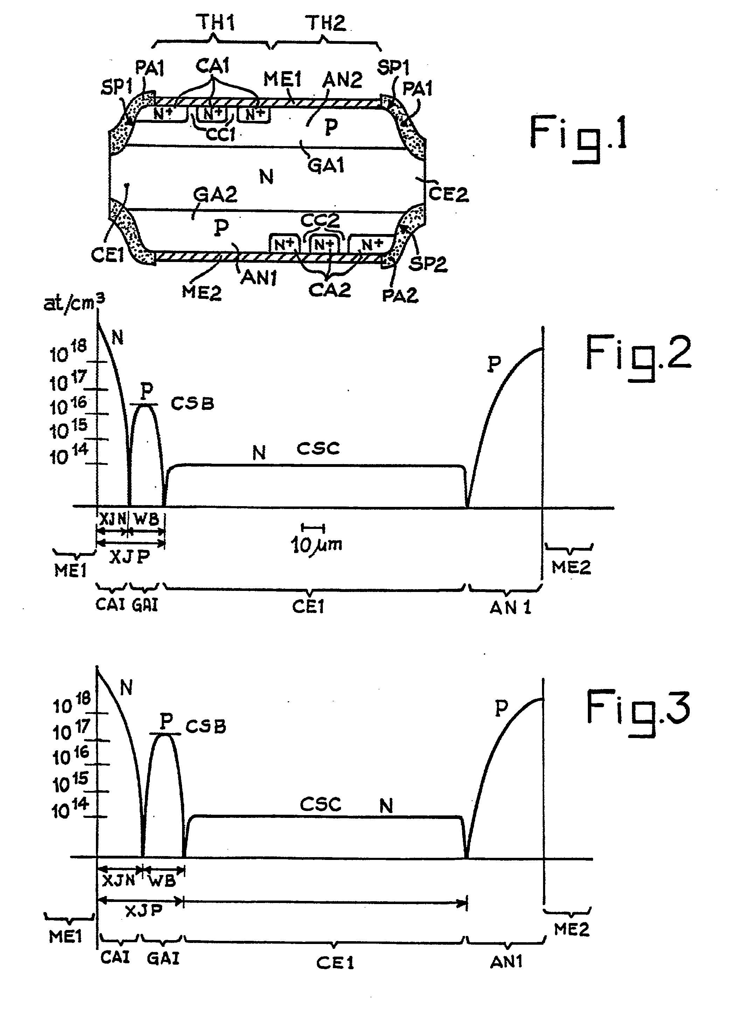

Une structure classique de triac est représentée à la figure 1. Les épaisseurs de couches sont parfaitement arbitraires sur cette figure. La structure comporte, sur une même pastille semiconductrice, deux thyristors (sans gâchette) juxtaposés TH1 et TH2 tête-bêche. Chaque thyristor comprend la superposition de quatre couches alternées : une région d'anode de type P (AN1 et AN2 respectivement) ; une région centrale de type N (CE1 et CE2), mais en fait la région centrale est commune aux deux thyristors et est constituée par le substrat de départ de la pastille ; une région de gâchette de type P (GA1, GA2) ; une région de cathode de type N (CA1, CA2) ; les surfaces supérieure et inférieure sont métallisées pour constituer une première électrode ME1 (cathode pour le thyristor TH1 et anode pour l'autre) et une deuxième électrode ME2 (anode pour le thyristor TH1 et cathode pour l'autre). Le pourtour de la pastille est en principe délimité sur chaque face par un sillon périphérique qui coupe la jonction entre la région centrale de type N et la région de type P adjacente à cette région du côté de la face considérée. Le sillon SP1 sur la face supérieure est recouvert d'une couche de passivation PA1 et le sillon SP2 sur l'autre face est recouvert d'une couche de passivation PA2 (verre). Des trous dits "court-circuits d'émetteur" CC1, CC2, sont prévus pour respectivement mettre en contact les métallisations de cathode (ME1, ME2) avec les régions de gâchette (GA1, GA2): ce sont des remontées de la couche de gâchette (GA1, GA2) à travers la couche de cathode (CA1, CA2) jusqu'à la métallisation de surface (ME1, ME2).

Les concentrations en impuretés dans les diverses régions superposées sont en principe symétriques pour les deux thyristors et on a représenté à la figure 2 un profil de concentration pour l'un des thyristors en partant d'une métallisation (ME1) jusqu'à l'autre (ME2).

Le profil représenté et les valeurs numériques indiquées sur ce profil et précisées ci-dessous correspondent à un triac de protection à faible courant de maintien ; autrement dit, en pratique on a représenté à la figure 2 le profil de concentration des couches d'un triac classique servant à la commutation commandée ; c'est en effet en utilisant d'abord des triacs classiques non pourvus d'électrodes de gâchette qu'on a commencé à réaliser des triacs de protection.

Sur ce profil on a désigné par :

XJN : la profondeur de la jonction entre la région de cathode CA1 et la région de gâchette GA1 (profondeur par rapport à la métallisation ME1),

XJP : la profondeur de la jonction entre la région de gâchette GA1 et la couche centrale CE1 (profondeur par rapport à la métallisation ME1),

WB : la "largeur de base" du thyristor, c'est-à-dire la largeur de la région de gâchette entre la couche centrale CE1 et la région de cathode CA1 ; WB est égal à XJP - XJN,

CSB : la concentration maximale de type P dans la région de gâchette,

CSC : la concentration (en principe constante) dans la région centrale CE1.

Pour un triac classique à courant de maintien assez bas, on aurait par exemple les profils de concentration typiques suivants :

Profil 1 : XJN = 15 $\mu$m
XJP = 33 $\mu$m
WB = 18 $\mu$m
CSB = 2 à 5 × $10^{16}$ atomes/cm$^3$
CSC = $10^{14}$ atomes/cm$^3$
Profil 2 : XJN = 15 $\mu$m
XJP = 50 $\mu$m
WB = 35 $\mu$m
CSB = 2 à 5 × $10^{16}$ atomes/cm$^3$
CSC = $10^{14}$ atomes/cm$^3$

Les régions d'anode et de cathode ont des concentrations beaucoup plus élevées (au moins $5 \times 10^{18}$ atomes/cm³).

Comme ces profils ne conduisent pas à des courants de maintien suffisants (à titre indicatif on peut souhaiter un courant de maintien de 150 mA) la solution normale qui vient à l'esprit est d'augmenter la largeur WB et la concentration CSB de la région de gâchette GA1 car cela diminue la résistivité de la région de gâchette.

En effet le triac se bloque dès lors que les chutes de tension engendrées latéralement dans la région de gâchette descendent au-dessous de 0,5 volts environ. Si on veut que le triac se bloque au-dessous d'un courant de maintien donné, il faut que la chute de tension soit suffisamment faible pour ce courant. On réduit la chute de tension en augmentant la conductivité de la région de gâchette, donc sa concentration et sa largeur.

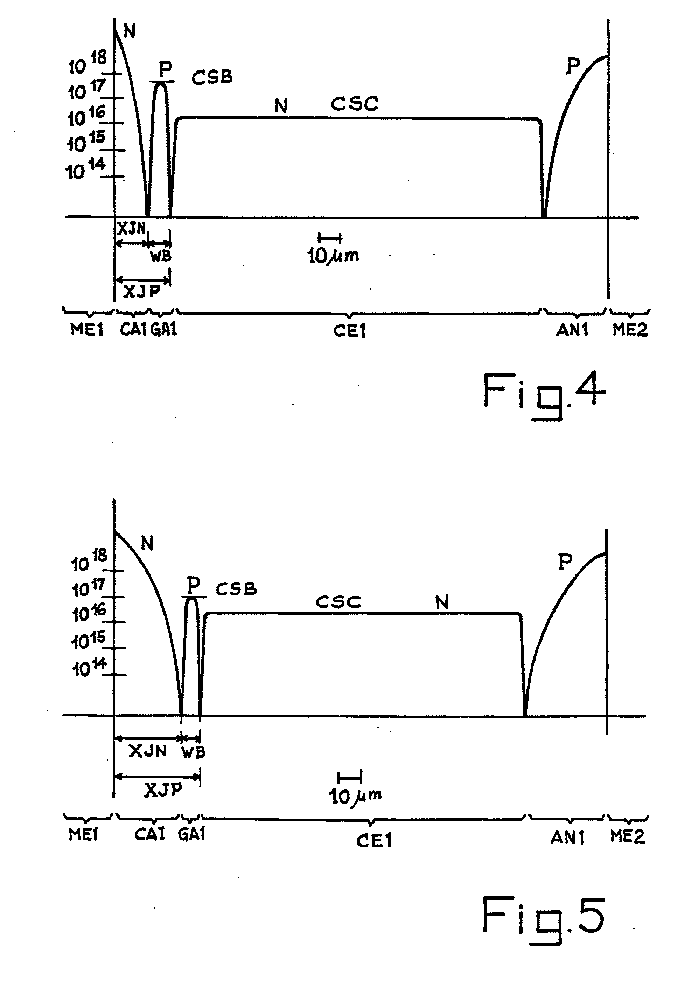

On a ainsi été amené à essayer un profil typique suivant
Profil 3 (fig.3) : XJN = 22 $\mu$m
XJP = 42 $\mu$m
WB = 20 $\mu$m
CSB = $3 \times 10^{17}$ atomes/cm³

On obtient effectivement grâce à ce changement des courants de maintien suffisants.

Mais la Demanderesse s'est aperçue que la tenue à des surcharges de courant était insuffisante et surtout n'était pas proportionnelle à la surface de la pastille semiconductrice. En particulier, après des essais on s'est aperçu que pour obtenir seulement 30 % d'amélioration de tenue en courant dans certaines conditions, il fallait plus que doubler la surface de la pastille (alors que classiquement on considère qu'une pastille peut laisser passer un courant maximum proportionnel à sa surface).

Plus précisément, avec une pastille ayant le profil 3 indiqué ci-dessus, on a mesuré le courant de destruction en présence d'une surintensité ayant les caractéristiques suivantes (ondes 8/20) : temps de montée 8 microsecondes jusqu'au maximum de la surintensité puis décroissance exponentielle avec réduction de 50 % de l'intensité au bout de 20 microsecondes.

Pour une pastille de 2,25 mm² le courant de destruction était de 170 ampères ; pour une pastille de 5,3 mm² (+ 135 % par rapport à 2,25 mm²) le courant de destruction étant de 220 ampères (+30 %).

La présente invention propose une structure de thyristor ou triac de protection qui améliore considérablement la tenue en courant pour des surfaces importantes tout en conservant un courant de maintien aussi important que celui des triacs mentionnés ci-dessus (profil 3).

Selon l'invention, la couche de gâchette a de manière inattendue une épaisseur WB particulièrement faible (inférieure à 10 $\mu$m), et une concentration en impuretés de type P comprise entre $5 \times 10^{16}$ et $5 \times 10^{18}$ atomes par centimètre cube; la région centrale a quant à elle une concentration en impuretés de type N d'au moins $10^{16}$ atomes/cm³, inférieure à la concentration de la couche de gâchette (fonction de la tension de retournement).

Listes des figures

- la figure 1 déjà décrite représente une structure de triac de protection,
- les figures 2 et 3 déjà décrites représentent des profils de concentration de triacs classiques,
- les figures 4 et 5 représentent des profils de concentration de thyristors ou triacs selon l'invention.

On ne reviendra pas sur la description précédente des figures 1 et 2.

Les figures 4 et 5 représentent les détails d'un profil de concentration typique selon l'invention.

Le tableau ci-dessous reprend deux exemples de valeurs numériques correspondantes :

Profil A (fig.4): XJN = 18 $\mu$m
XJP = 27 $\mu$m
WB = 9 $\mu$m
CSB = $6,5 \times 10^{17}$ atomes/cm³ environ
CSC = $3 \times 10^{16}$ atomes/cm³ environ

De plus, la largeur de la région CE1 peut être d'environ 180 $\mu$m et celle de la région AN1 de 30 $\mu$m environ. La concentration maximale des régions AN1 et CA1 est supérieure à $5 \times 10^{18}$ atomes/cm³.

Profil B (fig. 5) : XJN = 33 $\mu$m
XJP = 41 $\mu$m
WB = 8 $\mu$m
CSB = $9,2 \times 10^{16}$ atomes/cm³ environ
CSC = $5 \times 10^{16}$ atomes/cm³ environ

De plus la largeur de la couche centrale CE1 est d'environ 160 $\mu$m et celle de la région AN1 de 40 $\mu$m environ. La concentration maximale des régions AN1 et CA1 est encore supérieure à $5 \times 10^{18}$ atomes/cm³.

Les essais effectués pour ces deux profils montrent qu'on obtient une amélioration considérable de la tenue en courant : pour une pastille de 2,25 mm² (profil 4) on a obtenu un courant de destruction de 300 ampères (onde 8/20) et pour une pastille de 5,3 mm² (profil 5) un courant de destruction de 600 ampères.

Le courant de maintien obtenu (supérieur à 150 milliampères) peut encore être augmenté en effectuant un dopage à l'or de la couche centrale CE1, CE2, dopage qui a pour effet de réduire la durée de vie des porteurs de cette couche.

Une irradiation électronique peut aussi être utilisée pour effectuer cette réduction de durée de vie.

## Revendications

1. Thyrostor (TH1, TH2) sans électrode de gâchette comprenant, dans un substrat semiconducteur, la superposition des quatre couches suivantes: une couche d'anode (AN1, AN2) de type P fortement dopée, une couche centrale (CE1, CE2) de type N peu dopée, une couche de gâchette (GA1, GA2) de type P moyennement dopée, et une couche de cathode (CA1, CA2) de type N fortement dopée, et deux électrodes (ME1, ME2) dont l'une (ME2, ME1) est en contact avec la couche d'anode (AN1, AN2) et l'autre (ME1, ME2) avec la couche de gâchette (GA1, GA2) et la couche de cathode (CA1, CA2), la couche de gâchette (GA1, GA2) ayant une épaisseur (WB) inférieure à 10 µm entre la couche de cathode (CA1, CA2) et la couche centrale (CE1, CE2) et une concentration en impuretés comprise entre $5 \times 10^{16}$ atomes/cm$^3$ et $5 \times 10^{18}$ atomes/cm$^3$, la couche centrale (CE1, CE2) ayant une concentration en impuretés d'au moins $10^{16}$ atomes/cm$^3$, inférieure à la concentration de la couche de gâchette (GA1, GA2).

2. Thyristor selon la revendication 1, caractérisé en ce que la couche centrale (CE1, CE2) est dopée avec des atomes tendant à réduire la durée de vie des porteurs de charge électriques dans cette couche, notamment des atomes d'or.

## Patentansprüche

1. Thyristor (TH1, TH2) ohne Triggerelektrode, der in einem Halbleitersubstrat eine Übereinanderlagerung der folgenden vier Schichten umfaßt: eine stark dotierte Anodenschicht (AN1, AN2) vom P-Typ, eine schwach dotierte Zentralschicht (CE1, CE2) vom N-Typ, eine Triggerschicht (GA1, GA2) mittlerer Dotierung vom P-Typ und eine stark dotierte Kathodenschicht (CA1, CA2) vom N-Typ, sowie zwei Elektroden (ME1, ME2), von denen je eine (ME2, ME1) mit der Anodenschicht (AN1, AN2) und die andere (ME1, ME2) mit der Triggerschicht (GA1, GA2) und der Kathodenschicht (CA1, CA2) in Kontakt steht, wobei die Triggerschicht (GA1, GA2) zwischen der Kathodenschicht (CA1, CA2) und der Zentralschicht (CE1, CE2) eine Dicke (WB) von weniger als 10µm und eine Verunreinigungskonzentration zwischen $5 \times 10^{16}$ Atomen/cm$^3$ und $5 \times 10^{18}$ Atomen/cm$^3$ aufweist, und wobei die Zentralschicht (CE1, CE2) eine Verunreinigungskonzentration von wenigstens $10^{16}$ Atomen/cm$^3$ besitzt, die geringer ist als die Konzentration der Triggerschicht (GA1, GA2).

2. Thyristor nach Anspruch 1, dadurch gekennzeichnet, daß die Zentralschicht (CE1, CE2) mit Atomen, insbesondere mit Goldatomen, dotiert ist, welche die Tendenz besitzen, die Lebensdauer der elektrischen Ladungsträger in dieser Schicht zu verringern.

## Claims

1. A thyristor (TH1, TH2) without a gate electrode comprising, in a semiconductor substrate, the four following superposed layers:
a heavily doped P type anode layer (AN1, AN2), a lightly doped N type central layer (CE1, CE2), a moderately doped P type gate layer (GA1, GA2) and a heavily doped N type cathode layer (CA1, CA2), and two electrodes (ME1, ME2), one of which (ME2, ME1) is in contact with the anode layer (AN1, AN2), and the other (ME1, ME2) with the gate layer (GA1, GA2) and the cathode layer (CA1, CA2), the gate layer (GA1, GA2) having a thickness (WB) of less than 10 µm between the cathode layer (CA1, CA2) and the central layer (CE1, CE2) and a concentration of impurities between $5 \times 10^{16}$ atoms/cm$^3$ and $5 \times 10^{18}$ atoms/cm$^3$, the central layer (CE1, CE2) having a concentration of impurities which is at least $10^{16}$ atoms/cm$^3$ and is less than the concentration of impurities in the gate layer (GA1, GA2).

2. A thyristor according to Claim 1, characterized in that the central layer (CE1, CE2) is doped with atoms tending to reduce the lifetime of the electric charge carriers in this layer, particularly gold atoms.

EP 0 194 936 B1

Fig.1

Fig.2

Fig.3

Fig.4

Fig.5